**Europäisches Patentamt**

(19) **European Patent Office**

**Office européen des brevets**

(11) Publication number: **0 042 498**
**B1**

(12) **EUROPEAN PATENT SPECIFICATION**

(45) Date of publication of patent specification: **20.08.86**     (51) Int. Cl.⁴: **H 01 L 31/06**

(21) Application number: **81104002.1**

(22) Date of filing: **25.05.81**

(54) **Solar cell device.**

(30) Priority: **23.06.80 US 161816**

(43) Date of publication of application:
**30.12.81 Bulletin 81/52**

(45) Publication of the grant of the patent:
**20.08.86 Bulletin 86/34**

(84) Designated Contracting States:
**DE FR GB IT**

(56) References cited:
**EP-A-0 007 878**
**DE-A-1 953 008**
**DE-A-2 609 051**
**DE-A-2 929 484**
**US-A-3 104 188**
**US-A-3 907 595**
**US-A-4 094 704**
**US-A-4 105 470**

**IEEE TRANSACTIONS ON ELECTRON
DEVICES, Vol. ED-27, No. 4, April 1980 New
York L. DALAL "Design Considerations for a-Si
Solar Cells" pages 662 to 670**

(73) Proprietor: **International Business Machines
Corporation
Old Orchard Road
Armonk, N.Y. 10504 (US)**

(72) Inventor: **Hovel, Harold John
Diane Court
Katonah New York 10536 (US)**

(74) Representative: **Hobbs, Francis John
IBM United Kingdom Patent Operations
Hursley Park
Winchester, Hants, SO21 2JN (GB)**

Courier Press, Leamington Spa, England.

## Description

This invention relates to solar cell devices, and more particularly to solar cell devices with a solar cell formed on each side of an insulating substrate.

H. Hovel, in "Novel Materials and Devices for Sunlight Concentrating Systems", IBM J. Res. and Dev., *22*, 112 (1978), describes the advantages of "multicolour" solar cells. By using several materials with different energy bandgaps in optical series, the usual energy losses which limit solar cell efficiencies to less than 30% are overcome.

U.S. Patent 4,094,704 describes a solar cell device comprising first and second photoactive materials deposited on opposite sides of a transparent insulating substrate.

Solar cell devices provided with reflective metallic layers forming a barrier with the adjacent semiconductor material are known from US—A—3 104 188 and US—A—3 907 595 while a reflection enhanced tandem cell system is described in the article of V. K. Dalal published in IEEE Transactions on Electron Devices, Vol. ED-27, April 1980, pages 662—670.

The invention seeks to provide an improved solar cell device which can have an efficiency approaching or exceeding 40%.

A solar cell device comprises a transparent insulating substrate having a first photoactive material deposited on one side thereof and a second photoactive material deposited on the opposite side thereof, the first photoactive material having a larger energy bandgap than that of the second photoactive material and the second photoactive material being responsive to light of different wavelengths to those of the light to which the first photoactive material is responsive, and is characterised, according to the invention, by the second photoactive material having formed thereon a reflective layer of a metal which forms a Schottky barrier with the second photoactive material said reflective metallic layer being provided with a metallic extension extending around the edge of the substrate and electrically connecting the solar cell on one side of the insulating substrate to the solar cell on the other side of the substrate.

Semiconductors grown upon foreign substrates are generally polycrystalline in nature unless special conditions prevail. As an example, layers of GaAs, GaAlAs, GaAsP, Si, Ge and others are polycrystalline when grown upon quartz which is a transparent insulating material. Under special conditions in which the substrate is monocrystalline and the lattice parameters of the semiconductor are close to those of the substrate, and where the temperature and other growth conditions are carefully chosen, a monocrystalline epitaxial semiconductor layer can be grown upon a transparent insulating substrate. Polycrystalline layers on transparent insulating substrates can form the basis for low cost, moderately high efficiency tandem solar cells while monocrystalline layers on transparent insulating substrates can form the basis for higher efficiency structures which may be more costly but which can be used in concentrating systems where efficiency is more important than cost (see the Hovel article mentioned above).

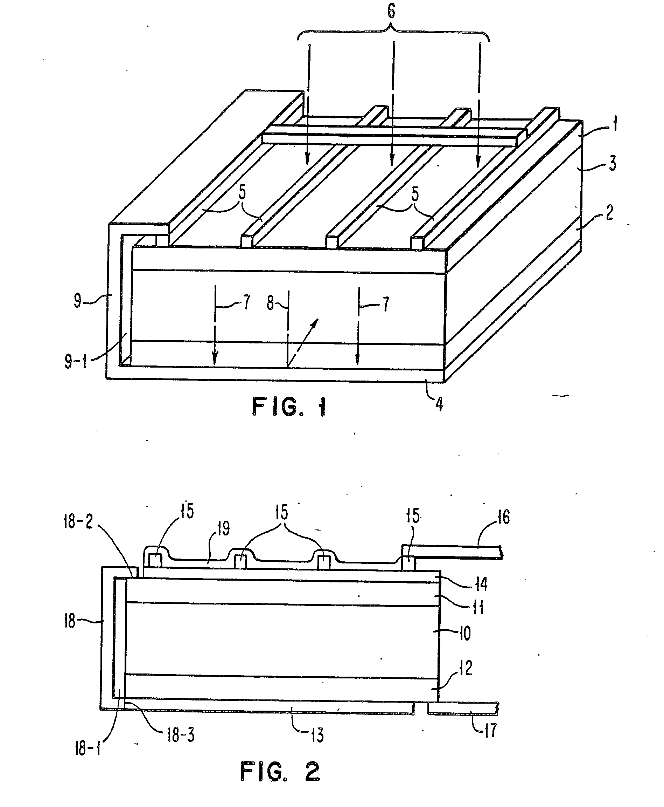

The invention will now be explained by way of example, with reference to the accompanying drawings in which two different solar cell devices embodying the invention are represented in Figs. 1 and 2 respectively.

In a first embodiment of the invention (FIG. 1), semiconductor layers 1 and 2 are deposited upon a transparent insulating substrate 3. A reflective metal layer 4 covers the bottom layer 2 and forms a Schottky barrier therewith, while a grid of metal 5 forms ohmic contact to the top layer 1. Light 6 enters through the top layer 1 which has a larger energy bandgap than layer 2. A portion of the light 7 whose photons have less energy than the energy bandgap of layer 1 is transmitted through the substrate to the semiconductor layer 2. A portion of the light 8 not absorbed by layer 2 on the first pass is reflected by the metal layer 4 and can be absorbed on the second pass. The reflective metal layer 4 is provided with an extension in the form of a metal layer 9 which is used to wrap-around the edges of the structure to ohmically connect the two solar cells via the metal grids 5. Region 9-1 may be an actual physical separation between wrap-around metal 9 and the regions 1, 2 and 3, or it may be an insulator acting as a stand-off to separate metal 9 from the semiconductor layers 1 and 2. In cases where metal 9 forms a low leakage electrical contact to semiconductor layers 1 and 2, metal 9 may touch layers 1 and 2 (as well as substrate 3) and the region shown as 9-1 will be absent. The layers 1 and 2 may be polycrystalline in general, but if the substrate and semiconductor layers and growth conditions are appropriately chosen, they may be epitaxial and monocrystalline. Techniques for choosing such conditions and materials are well known to crystal growth specialists.

The necessary devices made on layers 1 and 2 can be formed with Schottky barriers, p—n homojunctions, or heterojunctions. FIG. 2 shows an example of a structure using two Schottky barriers. Semiconductor layers 11 and 12 are deposited upon transparent insulating substrate 10. These semiconductor layers may be, for example, n-type conducting layers. Schottky barriers are formed by metal layers 13 and 14. Layer 14 is very thin, 60 to 200 Angstroms thick, so it is highly transparent to visible light. A grid 15 makes contact to the thin layer 14. The output electrodes are 16 and 17. Electrode 17 makes an ohmic contact to semiconductor 12 while wrap-around metal 18, shown connected at 18-3 to the metal layer 13 so it forms an extension thereof, makes ohmic contact to semiconductor layer 11. Region 18-1 may be an actual physical separation between wrap-around metal 18 and the substrate 10, and the layers 11 and 12 or it may be an insulator acting as a stand-off to separate metal

18 from the semiconductor layers 11 and 12. Metal 18 touches and makes ohmic contact to layer 11 at point 18-2. In cases where metal 18 forms a low leakage electrical contact to semiconductor layer 12, metal 18 may touch layer 12 (as well as substrate 10 and layer 11) and the region shown as 18-1 will be absent. Layer 13 is a thick optically reflective metal layer. An anti-reflection layer 19 can be used to maximize the transmittance of light through the thin metal layer 14.

Each of the FIGS. 1 and 2 has shown a wraparound contact which electrically connects the two solar cells.

Suitable transparent substrate materials include spinel, quartz, berylium oxide, zinc sulfide, sapphire, alumina, and glass. Suitable semiconductor materials include Ge, crystalline Si, GaSb, InP, GaAs, GaInAs, GaAsP, GaAlAs, CdS, CdSe, CdTe, amorphous Si and GaP.

Each of the structures of FIGS. 1 and 2 can be made with either polycrystalline or monocrystalline semiconductor layers. For highest efficiency of conversion of solar energy to electrical energy, single crystal layers are desired with electrical properties as close to bulk properties as possible. A crystal perfection accommodation region may then be desirable between the substrate and the active semiconductor layer. Crystal perfection accommodation regions are described in U.S. Patent 4,202,704. The crystal perfection accommodation region may be a wide bandgap semiconductor which "grades" the lattice properties of the substrate towards those of the active semiconductor layer and therefore reduces the defect density that would occur in the active layer.

## Claims

1. A solar cell device comprising a transparent insulating substrate (3; 10) having a first photoactive material (1; 11) deposited on one side thereof and a second photoactive material (2; 12) deposited on the opposite side thereof, the first photoactive material having a larger energy bandgap than that of the second photoactive material and the second photoactive material being responsive to light of different wavelengths to those of the light to which the first photoactive material is responsive, the solar cell device being characterised by the second photoactive material having formed thereon a reflective layer (4; 13) of a metal which forms a Schottky barrier with the second photoactive material said reflective metallic layer being provided with a metallic extension (9; 18) extending around the edge of the substrate and electrically connecting the solar cell on one side of the insulating substrate to the solar cell on the other side of the substrate.

2. A solar cell device as claimed in claim 1, in which the metallic extension (9) of the reflective metal layer (4) contacts a metallic grid (5) which forms an ohmic contact to the first photoactive material (1).

3. A solar cell device as claimed in claim 1, in which a transparent metallic layer (14) is formed on the first photoactive material (11) so as to form a solar cell having a Schottky barrier, and the metallic extension (18) of the reflective metal layer (13) makes an ohmic contact (at 18-2) with a portion of the first photoactive material.

4. A solar cell device as claimed in any preceding claim, in which the transparent insulating substrate is of material selected from $Al_2O_3$, Spinel, Quartz, BeO, Glasses and Aluminas.

5. A solar cell device as claimed in any preceding claim, in which the first photoactive material is selected from GaAs, GaAlAs, GaP, amorphous Si, GaAsP, CdS, CdSe and CdTe.

6. A solar cell device as claimed in any preceding claim, in which the second photoactive material is selected from crystalline Si, Ge, GaSb, GaInAs, and InP.

## Patentansprüche

1. Solarzellenvorrichtung, mit einem transparenten isolierenden Substrat (3, 10) versehen und mit einem ersten photoaktiven Werkstoff (1, 11) auf einer Seite sowie mit einem zweiten, auf der entgegengesetzten Seite davon aufgebrachten photoaktiven Werkstoff (2, 12) vervollständigt, wobei der erste photoaktive Werkstoff eine breitere Energiebandlücke besitzt als der zweite photoaktive Werkstoff und der zweite photoaktive Werkstoff auf Licht mit Wellenlängen anspricht, die sich von denen, auf die der erste photoaktive Werkstoff anspricht, unterscheiden und die Solarzellenvorrichtung weiter dadurch gekennzeichnet ist, dass der zweite photoaktive Werkstoff eine darauf reflektierende Schicht (4, 13) mit einem Metall gebildet hat, das zusammen mit dieser zweiten photoaktiven Schicht eine Schottky-Barriere bildet, und dass die genannte reflektierende Metallschicht mit einer metallenen Erweiterung (9, 18) versehen ist, die sich rund um den Rand des Substrats erstreckt und die Solarzelle auf den einen Seite des isolierenden Substrats elektrisch mit der Solarzelle auf der anderen Seite des Substrats verbindet.

2. Solarzellenvorrichtung nach Anspruch 1, in welcher die metallene Erweiterung (9) der reflektierenden Schicht (4) ein Metallgitter (5) berührt, das in Ohmschem Kontakt mit dem ersten photoaktiven Werkstoff (1) steht.

3. Solarzellenvorrichtung nach Anspruch 1, in welcher eine transparente Metallschicht (14) derart auf dem ersten photoaktiven Werkstoff (11) aufgebracht wird, dass sie eine Solarzelle mit einer Schottky-Barriere bildet, und die metallene Erweiterung (18) der reflektierenden Metallschicht (13) einen Ohmschen Kontakt (bei 18-2) mit einem Teil des ersten photoaktiven Werkstoffs herstellt.

4. Solarzellenvorrichtung nach einem beliebigen der vorstehenden Ansprüche, in welcher das transparente isolierende Substrat ein Werkstoff ist, der zwischen $Al_2O_3$, Spinell, Quarz, BeO, Glas und Aluminium ausgewählt wurde.

5. Solarzellenvorrichtung nach einem beliebigen der vorstehenden Ansprüche, in welcher der erste photoaktive Werkstoff zwischen GaAs, GaAlAs, GaP, amorphem Si, GaAsP, CdS, CdSe und CdTe ausgewählt wird.

6. Solarzellenvorrichtung nach einem beliebigen der vorstehenden Ansprüche, in welcher der zweite photoaktive Werkstoff zwischen kristallinem Si, Ge, GaSb, GaInAs und InP ausgewählt wird.

**Revendications**

1. Cellule solaire comportant un substrat isolant transparent (3; 10) dont l'un des côtés est recouvert d'un premier matériau photosensible (1; 11) et dont le côté opposé est recouvert d'un second matériau photosensible (2; 12), ledit premier matériau ayant une bande interdite d'énergie plus large que celle dudit second matériau, et ce dernier répondant à la lumière dont les longueurs d'onde diffèrent de celle à laquelle répond ledit premier matériau, caractérisée en ce que le second matériau photosensible est recouvert d'une couche réfléchissante (4; 13) d'un métal qui forme une barrière de Schottky avec le second matériau photosensible, ladite couche métallique réfléchissante comportant une extension métallique (9; 18) qui s'étend autour du bord du substrat et qui établit une connexion électrique entre la partie de la cellule solaire située de l'un des côtés du substrat isolant et la partie de celle-ci située de l'autre côté du substrat.

2. Cellule solaire selon la revendication 1, dans laquelle l'extension métallique (9) de la couche métallique réfléchissante (4) se trouve en contact avec une grille métallique (5) qui forme un contact ohmique avec le premier matériau photosensible (1).

3. Cellule solaire selon la revendication 1, dans laquelle une couche métallique transparente (14) est déposée sur la premier matériau photosensible (11) de manière à former une cellule solaire comportant une barrière de Schottky, et dans laquelle l'extension métallique (18) de la couche métallique réfléchissante (13) établit un contact ohmique (en 18-2) avec une partie du premier matériau photosensible.

4. Cellule solaire selon l'une quelconque des revendications précédentes, dans laquelle le substrat isolant transparent se compose d'un matériau choisi parmi les matériaux suivants: $Al_2O_3$, spinelle, quartz, BeO, verres et alumines.

5. Cellule solaire selon l'une quelconque des revendications précédentes, dans laquelle le premier matériau photosensible est choisi parmi les matériaux suivants: GaAs, GaAlAs, GaP, Si amorphe, GaAsP, CdS, CdSe et CdTe.

6. Cellule solaire selon l'une quelconque des revendications précédentes, dans laquelle le second matériau photosensible est choisi parmi les matériaux suivants: Si cristallin, Ge, GaSb, GaInAs et InP.

FIG. 1

FIG. 2